# EUROPEAN PATENT SPECIFICATION

(11) **EP 0 385 782 B1**
(45) Date of publication and mention of the grant of the patent: **20.12.1995**
(21) Application number: 90302201.0
(22) Date of filing: 01.03.1990
(51) Int. Cl.: H04M 1/60, H03G 7/00, H03G 3/20

(54) **Time dependent, variable amplitude threshold output circuit for frequency variant and frequency invariant signal discrimination**
Zeitabhängige und amplitudenveränderliche Schwellenausgangsschaltung zur frequenzabhängigen und frequenzunabhängigen Signaldiskriminierung
Circuit de génération d'un seuil à amplitude variable en fonction du temps pour une discrimination du signal dépendante et indépendante de la fréquence

(30) Priority: 02.03.1989 US 318073
(43) Date of publication of application: 05.09.1990
(73) Proprietor: ACS Wireless, Inc., Scotts Valley, California 95066 (US)
(72) Inventor: Lynn, Dwight D., Santa Cruz, California 95060 (US)
(74) Representative: Jackson, David Spence

(56) References cited:
- DE-A- 3 231 108
- US-A- 4 075 573
- US-A- 4 112 384
- PATENT ABSTRACTS OF JAPAN vol. 9, no. 189 (E-333)4 April 1985& JP-A-60 058 707

## Description

This invention relates to a signal compression method comprising providing an output signal by amplifying an input signal by a gain corresponding to a variable gain control voltage, the method including the steps of:
comparing the output signal with a threshold having a predetermined level, and
determining the variable gain control voltage in dependence upon the result of the comparison of the output signal and the threshold in such a manner than the said gain is less when the output signal is greater than the predetermined level of the threshold.

The invention also relates to signal compression apparatus.

The telephone system is more widely used now than ever before. The increasing convenience and economics of its use make it possible not only to convey information readily, but also to open its use to all social and economic levels. However, the increased use of the system has magnified some of its hazards.

Transient, impulse and large continuous noise tones appear within the telephone system. These tones may be caused by systems testing, power crosses, misdialed calls to facsimile machines or computer modems, lightning strikes or a variety of other events. Although the probability of experiencing the annoyance and surprise of these occurrences has increased, they have not generally been considered a hazard with a telephone handset. A telephone handset is typically held in the user's hand and can be quickly removed from the user's ear if uncomfortable noise levels are encountered. However, this is not the case with telephone headsets.

Because a telephone headset is worn by its user and cannot be quickly removed from the user's ear, noise level standards have been developed to protect the user. Institutions that use a large number of telephones usually require noise protection devices in all telephone headsets. Furthermore, headsets with volume controls are required to incorporate automatic gain control (AGC) circuitry for limiting the amplitude of the earphone speaker output by some headset users.

To properly protect against continuous noise, the U.S Occupational Safety and Health Administration (OSHA) has established a 95dBA limit for a signal exposure of 4.0 hours per day. This is the estimated on-line time of a telephone operator during an average 8 hour shift based on telephone industry data. The designation "dBA" is 20 times the log of a sound level with respect to 20 microPascals, which is 'A' weighted and time averaged.

To protect against continuous high-level sound signals, AGC circuitry is normally adjusted so that the earphone speaker output will not exceed 95 dBSPL. The term "dBSPL" refers to "sound pressure level", which is the same as "dBA" except that the 'A' weighting curve is removed along with the time averaging. Limiting sound to a dBSPL rating is easily accomplished by the use of AGC circuitry with peak detecting control.

Within the difference between the "dBA" and "dBSPL" sound ratings, there lies a problem. The "dBA" limit allows for the acoustic peaks and valleys that normally occur in speech by virtue of its time averaging feature. However, the peak detection methods required by the "dBSPL" circuits do not. The crest factor of a continuous sine wave is 1.414, whereas the crest factor of normal speech may exceed 5 (the "crest factor" can simply be described as the ratio of a waveform's "peak" value to the "rms" value).

Because of the crest factor, AGC circuitry will limit human voice signals to a level far below 95dBA. User safety with respect to peaks and continuous sound is preserved with this limit, but the level of human voice output signal from the earphone speaker in normal environments is difficult to understand. This has its own deleterious effect by adding user stress because of the strain required to hear the signal and by decreasing productivity due to the repeated questions and statements required during conversations.

The optimum solution is to limit voice and continuous signals equally to 95dBA. However, the crest factor of the two signal types does not allow an easily integratable peak detecting limiter circuit to be utilized.

Prior art techniques utilize variable gain circuitry that can be controlled by automatic means through a feedback control voltage. According to these techniques, when a signal is propagated through the amplifier, it is unaffected until the signal's instantaneous amplitude crosses the compression threshold. A feedback control voltage is then generated which forces the amplifier gain to decrease by a fixed amount. A peak detector is employed to aid in circuit integration. The attack time is limited to avoid "pops" or "clicks" from being generated by an abrupt gain change. A decay time from compression is also employed to maintain a relatively constant gain between syllables or utterances.

DE-A-32 31 108 (corresponding to GB-A-2 106 355) describes a telephone headset that includes a receiver conditioning circuit that operates in accordance with a method of the kind defined hereinbefore at the beginning. The receiver conditioning circuit has a compression function that is intended to protect the user's eardrums from acoustic shock by signals of excessive amplitude. The compression function results in the effective amplification of an incoming electrical voice signal being varied as a function of the magnitude of the signal, the effective gain being reduced for signal magnitudes above a compression threshold level. Electrical voice signals from a telephone hybrid circuit are applied through a symmetrical resistive attenuator, with d.c. blocking capacitors, to the input terminals of a differential amplifier which operates on the principle of the gain of the amplifier decreasing as the operating current for the amplifier is reduced. The operating current is supplied to the amplifier by a current source that is controlled by a compression control circuit. Output from this variable gain differential amplifier is further amplified by a buffer amplifier and then a power amplifier before being capacitively coupled to a series combination of an impedance matching resistor and a receiver transducer. The output voltage across this series combination is applied to the non-inverting input terminal of a compressor detector in the form of a differential amplifier, the inverting input terminal of which is supplied with a compression threshold set by a constant current passing through parallel connected resistors to ground. The output of the compressor detector controls the compression control circuit. A capacitor and resistors associated with the compression control circuit determine the attack and decay times of the variable gain differential amplifier. A gain adjustment potentiometer is used to couple the output of the buffer amplifier to the input of the power amplifier.

Other prior art techniques improve upon the above-described system by making the decay time dependant upon the amount of time the circuit is in compression. This method tends to run higher output levels because the short, normally occurring peaks in the voice only cause a short decay time. Therefore, the circuit returns to full gain in a shorter period of time.

US-A-4 112 384 describes a voice detection system which includes an automatic gain control amplification circuit. The voice signal amplifying part of the circuit consists of a variable attenuator input stage supplying an attenuated or unattenuated signal to a fixed gain operational amplifier. The overall gain of the amplifying part is determined by the attenuation effected by the variable attenuator input stage. This attenuation is determined by the voltage across a capacitor. This voltage is in turn determined by the operation of a peak detector connector to compare the amplified output with a threshold level, and a signal fed back from the output of voice detecting circuitry fed by the amplified output. The peak detector controls the capacitor voltage so as to increase the attenuation if the threshold level is exceeded. The voice detecting circuitry simultaneously controls the capacitor voltage so as to decrease the attenuation when a voice signal is present. Thus the voice detection system is intended to be protected from responding to background noise that is not speech. The system can also be implemented in a digital form in which an up/down counter takes the place of the capacitor and the attenuator is a set of shunt resistors controlled by analog switches operated by the counter. The peak detector controls the supplying of clock pulses to the up counting input of the counter, and the voice detector circuitry controls the supplying of clock pulses to the down counting input of the counter.

According to one aspect of the invention there is provided a method of the kind defined hereinbefore at the beginning, characterised by measuring the length of time throughout which the output signal is continuously greater than the predetermined level of the threshold, and if the measured length of time is a predetermined period of time, switching the threshold to a further predetermined level that is lower than the first said predetermined level.

According to another aspect of the invention there is provided signal compression apparatus comprising:
means for amplifying an input signal by a gain corresponding to a variable gain control voltage to provide an output signal, the variable gain control voltage being applied to the amplifying means;
means for comparing the output signal with a threshold having a predetermined level and providing a comparator output determined by the relationship between the output signal and the predetermined level of the threshold; and
means responsive to the comparator output for providing the variable gain control voltage, such that the said gain is less when the output signal is greater than the predetermined level, characterised by means for measuring the length of time throughout which the output signal is continuously greater than the predetermined level of the threshold and for switching the threshold to a further predetermined level if the measured length of time is a predetermined period of time, the further predetermined level being lower than the first said predetermined level.

Embodiments of the invention are intended to be used in communications equipment and, in particular, in apparatus for multi-level control of signals in telephone headsets and handsets.

A preferred embodiment of the present invention takes the form of a voice signal compression system wherein the compression threshold may be adjusted to a calibrated level. The system includes a variable gain amplifier for amplifying the voice input signal. The amplifier gain is controlled based on the application of a variable voltage. A driver increases the power gain of the amplified input signal to provide a power-boosted output. In addition to being applied to an acoustic output transducer, the power-boosted output is also applied both to a peak detecting comparator and to a threshold reset timer. The comparator produces a digital output that triggers an attack/decay timing generator which produces the control voltage for the variable gain amplifier. The comparator initially is set to a high threshold state by the threshold reset timer. As the signal levels and peaks of the input signal increase, the comparator begins to trigger digital pulses to the attack/ decay timer whenever the power-boosted output exceeds the threshold of the comparator. At the same time, the threshold reset timer begins measuring the duration of a signal which exceeds the threshold of the comparator. If the threshold reset timer detects that the level of the power-boosted output exceeds the threshold of the comparator for a preselected time, then the compression threshold of the comparator is switched to a lower level. The comparator threshold remains low until the continuous signal is removed. At this point, the circuit is reset to its normal mode of operation.

Thus, the voice signal compression system accomplishes the task of allowing headset or handset users to listen to speech at more natural levels, to be protected from loud noises or speech by virtue of the initial high level compression threshold,and to be ultimately protected from continuous noises or tones that normally exist in the telephone system.

The invention will now be described by way of example with reference to the accompanying drawings, in which:-

Figure 1 is a timing diagram illustrating the waveform envelopes resulting from operation of a tri-level compression system in accordance with the present invention.

Figure 2 is a block diagram illustrating a tri-level compression circuit in accordance with the present invention.

Figure 3 is a timing diagram illustrating various waveforms generated in the operation of the Fig. 2 circuit.

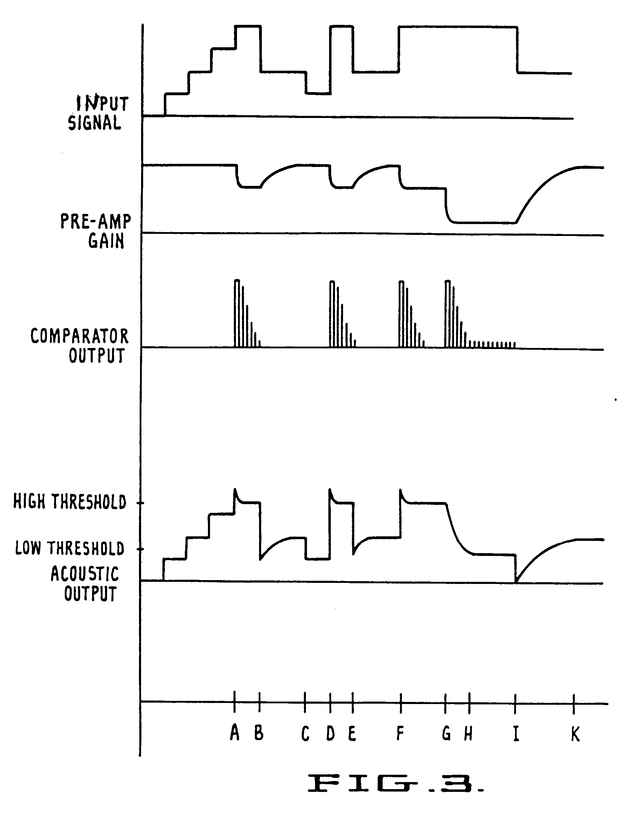

Fig. 2 represents a tri-level compression circuit 10 embodying the present invention in the form of a voice signal compression system wherein, rather than setting a compression threshold for a maximum continuous tone level of 95dBA as in the prior art techniques, the compression threshold is adjusted to a calibrated level which is perceived to be 95dBA. This level is approximately 100dBSPL for a continuous 1KHz tone and was obtained using a subjective loudness balance method recommended in AT&T Technologies Specification KS23081.

It should be noted that a 1KHz tone at 100dBSPL is 100dBA. The 'A' weighting curve does not alter the 1KHz frequency response of the system and the average RMS value of a continuous tone is the RMS value.

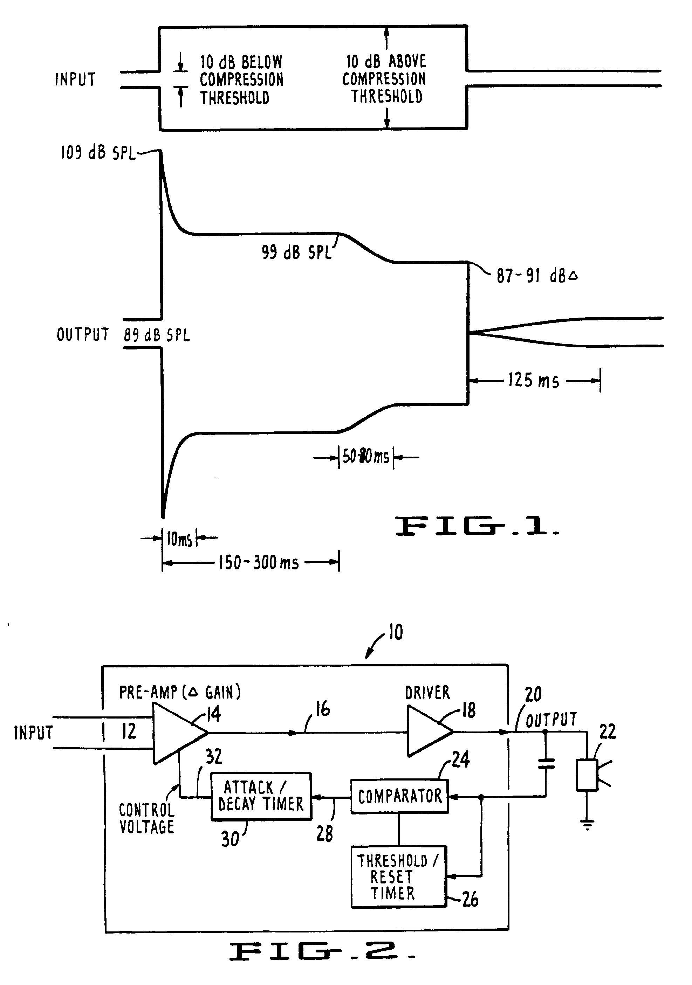

If, however, as illustrated in Fig. 1, a continuous tone is applied to the compression system of Fig. 2 for a time period of about 175-300ms, preferably about 200ms, the compression threshold is lowered 10dB. The result is that voice signals are safely maintained within the prescribed limits and continuous tones are lowered to 90dBA within 175-300ms of initial user exposure.

OSHA allows a user exposure of 100dBA for two hours per day. A 90dBA user exposure would be allowed for approximately 8 hours per day as shown from Table N-1 of the CAL/OSHA Noise Control Handbook, S-680.

As described in greater detail below, a reset timer is used to prevent the compression system from switching to the low compression level mode during speech. Although human speech may sound continuous, it is, in fact, many utterances separated by periods of near silence. Some utterances may exceed 100ms, while the period of silence may be 5 to 20ms. Thus, incorporating a 150-300ms delay before adjusting the compression threshold downward substantially avoids the problem of going to the low compression mode during speech. To ensure this, a 10ms reset timer is used. The 10ms reset timer resets the 150-300ms compression level switching circuit. Therefore, at the end of most utterances, the compression circuit is reset and begins waiting for another utterance, sound or noise that persists for longer than 200ms. Once the lower compression level is achieved, it is maintained until a 10ms break appears.

The tri-level compression circuit 10 that provides the above-described signal control in accordance with the present invention includes five functional blocks. A differential input 12 representative of the signal received by the headset over the telephone lines is applied to a floating differential pre-amplifier 14. The gain of the pre-amplifier 14 is controlled and initially established at a pre-determined gain level by attack/decay timer 30 via control voltage 32. The gain of the pre-amplifier 14 may be reduced by changing the control voltage 32, as described in greater detail below. In the Fig. 2 embodiment of the invention, the output 16 of the pre-amplifier 14 is applied to a driver 18 which increases the power gain of the signal 16. The power-boosted output 20 is then applied to an acoustic output transducer 22.

The driver output 20 is also applied both to a peak detecting comparator 24 and to a threshold reset timer 26.

The comparator 24 produces a pulsed digital output 28 that triggers an attack/decay timing generator 30 which produces to analog control voltage 32. As shown in Fig. 2, this control voltage 32 directly controls the gain of the input stage pre-amplifier 14.

There are two operational levels of compression threshold. The high level is the normal, initial level that allows voice output at normal hearing levels. The comparator 24 initially is set to the high threshold state by the threshold reset timer 26. If the levels and peaks of input signal 12 increase sufficiently to cause the power-boosted output 20 to exceed the threshold of comparator 24, the comparator 24 begins to generate trigger pulses 28 which are supplied to the attack/decay timer 30. Concurrently, the threshold reset timer 26 begins measuring the duration of the signal which exceeds the threshold of comparator 24. The high threshold is set to safe and comfortable listening levels. The threshold reset timer 26 is continually being reset by naturally occurring breaks in the voice signal. When the incoming signal 12 is continuous enough to allow the threshold reset timer 26 to set, the compression threshold of comparator 24 is switched to a level approximately 10 dB lower than the initial level. As shown in Fig. 1, the resulting change in output level occurs over a time period of approximately 80ms. The threshold remains low until the continuous signal is removed. At this point, the circuit is reset to its normal mode of operation.

Operation of the tri-level compression circuit of the present invention may be illustrated by reference to the waveforms shown in Fig. 3. As shown in Fig. 3, prior to time A, the pre-amplifier 14 is at maximum gain. Nothing is happening because the output signal has not exceeded the high compression threshold. At time A, the input signal is high enough to force the acoustic output over the high compression threshold. The comparator 24 then generates pulses that cause the control voltage 32 to change. Therefore, the pre-amp gain decreases and the output signal level decreases. At time B, the input signal has decreased sufficiently to force the output below the high compression threshold and the circuit returns to normal operating conditions. At time C, pre-amp 14 is again at full gain and is exactly following the input signal. The "D to E" time period shows the same results as times A and B with different input signal characteristics. At time F, the system goes into compression and holds the level for 200ms. Time G shows that the input signal is still high after 200ms. The output is then determined by the low level threshold mode due to the threshold shifting of the tri-level circuitry. At time H, the gain has stabilized after about 60ms with the low threshold. At time I, the input level has returned to a normal level and, thus, the compression threshold has also been reset to its high level. At time K, the gain is at the nominal level after the decay time.

It should be understood that various alternatives to the embodiment of the invention described herein may be employed in practicing the invention. It is intended that the following claims define the invention and that structures within the scope of these claims and their equivalents be covered thereby.

## Claims

1. A signal compression method comprising providing an output signal (20) by amplifying (14,18) an input signal (12) by a gain corresponding to a variable gain control voltage (32), the method including the steps of:
comparing (24) the output signal (20) with a threshold having a predetermined level, and
determining (24,30) the variable gain control voltage (32) in dependence upon the result of the comparison of the output signal (20) and the threshold in such a manner that the said gain is less when the output signal (20) is greater than the predetermined level of the threshold, characterised by
measuring (26) the length of time throughout which the output signal (20) is continuously greater than the predetermined level of the threshold, and, if the measured length of time is a predetermined period of time, switching (26) the threshold to a further predetermined level that is lower than the first said predetermined level.

2. Signal compression apparatus comprising:
means (14,18) for amplifying an input signal (12) by a gain corresponding to a variable gain control voltage (32) to provide an output signal (20), the variable gain control voltage (32) being applied to the amplifying means (14,18) ;
means (24) for comparing the output signal (20) with a threshold having a predetermined level and providing a comparator output (28) determined by the relationship between the output signal (20) and the predetermined level of the threshold; and
means (30) responsive to the comparator output (28) for providing the variable gain control voltage, such that the said gain is less when the output signal (20) is greater than the predetermined level, characterised by means (26) for measuring the length of time throughout which the output signal (20) is continuously greater than the predetermined level of the threshold and for switching the threshold to a further predetermined level if the measured length of time is a predetermined period of time, the further predetermined level being lower than the first said predetermined level.

3. Signal compression apparatus according to claim 2, characterised in that the amplifying means comprises a variable gain amplifier (14) for receiving the input signal (12) and the variable gain control voltage (32), and a power-amplifying driver (18) for outputting the said output signal (20), the variable gain amplifier (14) having its output coupled to the input of the driver (18), the comparing means comprises a comparator (24) adapted to generate a pulsed output signal if the said output signal (20) exceeds the level of the threshold, the measuring and switching means comprises a threshold and resettable timer circuit (26) having timing means that reset the time measurement in response to detection of a defined interruption or termination of the said output signal (20) exceeding the level of the threshold, and the means responsive to the comparator output (28) comprises an attack/decay timer (30) responsive to the said pulsed output signal.

4. Signal compression apparatus according to claim 3, characterised in that the defined interruption is a cessation of at least 10 milliseconds.

5. Signal compression apparatus according to claim 2 or 3, characterised in that the amplifying means (14,18) is voice frequency amplifying means and is adapted to receive as the input signal (12) a differential signal supplied by telephone lines.

## Patentansprüche

1. Signalkomprimierungsverfahren, bei dem ein Ausgangssignal (20) durch Verstärken (14, 18) eines Eingangssignals (12) mittels einer Verstärkung, die einer variablen Verstärkungssteuerspannung (32) entspricht, erzeugt wird, wobei das Verfahren die Schritte enthält:
Vergleichen (24) des Ausgangssignals (20) mit einem Schwellwert, der einen vorbestimmten Pegel besitzt, und
Bestimmen (24, 30) der variablen Verstärkungssteuerspannung (32) in Abhängigkeit von dem Ergebnis des Vergleichs zwischen dem Ausgangssignal (20) und dem Schwellwert in einer solchen Weise, daß die Verstärkung geringer ist, wenn das Ausgangssignal (20) größer ist als der vorbestimmte Pegel des Schwellwerts, gekennzeichnet durch
das Messen (26) der zeitlichen Länge, während derer das Ausgangssignal (20) durchgehend kontinuierlich größer ist als der vorbestimmte Pegel des Schwellwerts, und Umschalten (26) des Schwellwerts auf einen weiteren vorbestimmten Pegel, der niedriger ist als der erste vorbestimmte Pegel, wenn die gemessene zeitliche Länge eine vorbestimmte Zeitdauer ist.

2. Signalkomprimierungsvorrichtung, mit
einer Einrichtung (14, 18) zum Verstärken eines Eingangssignals (12) mittels einer Verstärkung, die einer variablen Verstärkungssteuerspannung (32) entspricht, um ein Ausgangssignal (20) zu erzeugen, wobei die variable Verstärkungssteuerspannung (32) an die Verstärkereinrichtung (14, 18) angelegt ist,
einer Einrichtung (24) zum Vergleichen des Ausgangssignals (20) mit einem Schwellwert, der einen vorbestimmten Pegel besitzt, und zum Erzeugen eines Vergleicher-Ausgangssignals (28), das durch die Beziehung zwischen dem Ausgangssignal (20) und dem vorbestimmten Pegel des Schwellwerts bestimmt ist, und
einer Einrichtung (30), die auf das Vergleicher-Ausgangssignal (28) zur Erzeugung der variablen Verstärkungssteuerspannung anspricht, derart, daß die Verstärkung geringer ist, wenn das Ausgangssignal (20) größer ist als der vorbestimmte Pegel, gekennzeichnet durch eine Einrichtung (26) zum Messen der zeitlichen Länge, während derer das Ausgangssignal (20) durchgehend kontinuierlich größer ist als der vorbestimmte Pegel des Schwellwerts, und zum Umschalten des Schwellwerts auf einen weiteren vorbestimmten Pegel, falls die gemessene zeitliche Länge eine vorbestimmte Zeitdauer ist, wobei der weitere vorbestimmte Pegel niedriger ist als der erste vorbestimmte Pegel.

3. Signalkomprimierungseinrichtung nach Anspruch 2, dadurch **gekennzeichnet**, daß die Verstärkereinrichtung einen Verstärker (14) mit variabler Verstärkung für das Aufnehmen des Eingangssignals (12) und der variablen Verstärkungssteuerspannung (32), sowie einen leistungsverstärkenden Treiber (18) für die Abgabe des Ausgangssignals (20) aufweist, wobei der Ausgang des Verstärkers (14) mit variabler Verstärkung mit dem Eingang des Treibers (18) gekoppelt ist, wobei die Vergleichseinrichtung einen Vergleicher (24) enthält, der zur Erzeugung eines gepulsten Ausgangssignals dann, wenn das Ausgangssignal (20) den Pegel des Schwellwerts überschreitet, ausgelegt ist, wobei die Meß- und Umschalteinrichtung einen Schwellwert und eine rücksetzbare Zeitgeberschaltung (26) aufweist, die eine Zeitgabeeinrichtung enthält, die die Zeitmessung als Reaktion auf die Erfassung einer definierten Unterbrechung oder Beendigung des Ausgangssignals (20), das den Pegel des Schwellwerts überschreitet, zurücksetzt, und wobei die Einrichtung, die auf das Vergleicher-Ausgangssignal (28) anspricht, einen Anstiegs/Verminderungs-Zeitgeber (30) enthält, der auf das gepulste Ausgangssignal anspricht.

4. Signalkomprimierungseinrichtung nach Anspruch 3, dadurch **gekennzeichnet,** daß die definierte Unterbrechung ein Aufhören für mindestens 10 ms ist.

5. Signalkomprimierungseinrichtung nach Anspruch 2 oder 3, dadurch **gekennzeichnet**, daß die Verstärkereinrichtung (14, 18) eine Sprachfrequenz-Verstärkereinrichtung ist und für den Empfang eines differentiellen Signals, das über Telefonleitungen zugeführt wird, als Eingangssignal (12) ausgelegt ist.

## Revendications

1. Un procédé de compression de signal comprenant la génération d'un signal de sortie (20) par l'amplification (14, 18) d'un signal d'entrée (12) avec un gain correspondant à une tension de commande de gain variable (32), le procédé comprenant les étapes suivantes :
on compare (24) le signal de sortie (20) avec un seuil ayant un niveau prédéterminé, et
on détermine (24, 30) la tension de commande de gain variable (32) sous la dépendance du résultat de la comparaison du signal de sortie (20) et de la tension de seuil, d'une manière telle que le gain soit inférieur lorsque le signal de sortie (20) est supérieur au niveau prédéterminé du seuil, caractérisé en ce que
on mesure (26) la durée pendant laquelle le signal de sortie (20) est continuellement supérieur au niveau prédéterminé du seuil, et si la durée mesurée est une durée prédéterminée, on commute (26) le seuil vers un niveau prédéterminé supplémentaire qui est inférieur au niveau prédéterminé mentionné en premier.

2. Dispositif de compression de signal comprenant :
des moyens (14, 18) pour amplifier un signal d'entrée (12) avec un gain correspondant à une tension de commande de gain variable (32), pour produire un signal de sortie (20), la tension de commande de gain variable (32) étant appliquée aux moyens d'amplification (14, 18);
des moyens (24) pour comparer le signal de sortie (20) avec un seuil ayant un niveau prédéterminé, et pour fournir un signal de sortie de comparateur (28) qui est déterminé par la relation entre le signal de sortie (20) et le niveau prédéterminé du seuil; et
des moyens (30) réagissant au signal de sortie de comparateur (28) en produisant la tension de commande de gain variable, d'une manière telle que le gain soit inférieur lorsque le signal de sortie (20) est supérieur au niveau prédéterminé, caractérisé par des moyens (26) destinés à mesurer la durée pendant laquelle le signal de sortie (20) est continuellement supérieur au niveau prédéterminé du seuil, et à commuter le seuil vers un niveau prédéterminé supplémentaire si la durée mesurée est une durée prédéterminée, le niveau prédéterminé supplémentaire étant inférieur au niveau prédéterminé mentionné en premier.

3. Dispositif de compression de signal selon la revendication 2, caractérisé en ce que les moyens d'amplification comprennent en amplificateur à gain variable (14) qui est destiné à recevoir le signal d'entrée (12) et la tension de commande de gain variable (32), et un étage d'attaque (18) ayant une fonction d'amplification de puissance, pour émettre le signal de sortie (20), la sortie de l'amplificateur à gain variable (14) étant connectée à l'entrée de l'étage d'attaque (18), les moyens de comparaison comprennent un comparateur (24) qui est conçu pour générer un signal de sortie impulsionnel si le signal de sortie (20) dépasse le niveau du seuil, les moyens de mesure et de commutation comprennent un circuit à seuil/temporisateur avec restauration (26), ayant des moyens de temporisation qui restaurent la mesure de temps sous l'effet de la détection d'une interruption définie ou d'une terminaison du signal de sortie (20) dépassant le niveau du seuil, et les moyens réagissant au signal de sortie de comparateur (28) comprennent un temporisateur d'attaque/décroissance (30) réagissant au signal de sortie impulsionnel.

4. Dispositif de compression de signal selon la revendication 3, caractérisé en ce que l'interruption définie est une cessation d'au moins 10 millisecondes.

5. Dispositif de compression de signal selon la revendication 2 ou 3, caractérisé en ce que les moyens d'amplification (14, 18) sont des moyens d'amplification à fréquence vocale et sont conçus pour recevoir pour le signal d'entrée (12) un signal différentiel qui est fourni par des lignes téléphoniques.
